# EUROPEAN PATENT APPLICATION

(11) **EP 4 715 394 A1**
(43) Date of publication of application: **25.03.2026**
(21) Application number: 25188432.6
(22) Date of filing: 09.07.2025
(51) Int. Cl.: G01R 1/04, G01R 31/28

(54) **PACKAGE RETENTION IN A TEST SOCKET BY A PRESSURIZED FLUID**

(30) Priority: 19.09.2024 US 202418889466
(71) Applicant: INTEL Corporation, Santa Clara, CA 95054 (US)
(72) Inventor: MURTAGIAN, Gregorio, Phoenix, 85045 (US); BALASUBRAMANIAN, Shyam-Sundar, Chandler, 85226 (US)
(74) Representative: Viering, Jentschura & Partner mbB Patent- und Rechtsanwälte

(57) **Abstract**

According to various aspects of the present disclosure, a semiconductor testing equipment may include a thermal head assembly having a body with a recess that is unobstructed and designed to fit over a die on the semiconductor package. A sealing member on the thermal head assembly engages a landing area on the semiconductor package to form a sealed chamber. The semiconductor package may be uniformly loaded by introducing a gas and incrementally increasing the gas pressure in the sealed chamber and increasing mechanical load on the sealing member onto the landing area to prevent leakage. Once the sealed chamber is fully sealed, the combined internal pressure from the circulating gas and a sealing perimeter load enables the proper socketing of the semiconductor package. Thereafter, the gas may be replaced with a circulating liquid refrigerant to remove the heat generated by the die during the testing of the semiconductor package.

## Description

### Background

For integrated circuit design and fabrication, the need to improve performance and lower costs are constant challenges. Various testing techniques are used during the semiconductor prototyping and manufacturing process, such as functional testing for the basic functions of integrated circuits (ICs), structural testing for identifying physical defects, parametric testing for analyzing the performance of a die under varying conditions (e.g., variations in temperatures), and reliability testing for assessing the durability and longevity of the die.

For the various testing techniques for ICs, there may be technical problems that also need to be addressed; for example, enhancing the cooling of bare semiconductor/die packages during back-end testing by eliminating thermal parasitic resistance from a thermal head stack, The package testing equipment includes other thermal parasitic resistance components such as a pedestal and pusher plate, which are positioned between the cooling fluid and the die. Advanced testing technologies may address these issues with what is known as zero parasitic element cooling (ZPEC).

For direct package cooling technologies, such as ZPEC, the thermal head may use stand-offs to actuate the semiconductor package to the interconnect socket. However, when a plurality of stand-offs are used, a bare die package may be subject to stress concentrations and hot spots caused by the stand-offs. The stress concentrations on the bare die package may potentially cause die cracking. The hot spots on the bare die package, which may be caused by obstructing fluid flow at the contact zone, may affect the die testing. In addition, the standoffs in the thermal head are costly to design and manufacture due to their high manufacturing tolerance requirements, i.e., being custom-made for each product. By eliminating the stand-offs from a ZPEC thermal head, a cost reduction may be possible and the stress concentrations and the hot spots beneath the stand-offs would be eliminated.

### Brief Description of the Drawings

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows an exemplary representation of a present semiconductor testing equipment having a thermal head assembly and test socket according to an aspect of the present disclosure;
FIGS. 2A through 2C show exemplary representations of a present semiconductor testing equipment having a thermal head assembly and test socket engaging a semiconductor package for testing according to an aspect of the present disclosure;
FIG. 3 shows an exemplary representation of an air and coolant fluid pressure cycle according to an aspect of the present disclosure;
FIG. 4 shows an exemplary representation of another thermal head assembly for a present semiconductor testing equipment according to an aspect of the present disclosure; and
FIG. 5 shows a simplified flow diagram for an exemplary method for ramping up the pressure for testing a semiconductor package according to an aspect of the present disclosure.

### Detailed Description

The following detailed description refers to the accompanying drawings that show, by way of illustration, specific details, and aspects in which the present disclosure may be practiced. These aspects are described in sufficient detail to enable those skilled in the art to practice the present disclosure. Various aspects are provided for devices, and various aspects are provided for methods. It will be understood that the basic properties of the devices also hold for the methods and vice versa. Other aspects may be utilized and structural, and logical changes may be made without departing from the scope of the present disclosure. The various aspects are not necessarily mutually exclusive, as some aspects can be combined with one or more other aspects to form new aspects.

According to the present disclosure, a solution to stress concentrations and hot spots may be provided by applying a load to a perimeter and a top surface of a semiconductor package, including the die, using only a pressurized fluid, which can ensure optimal contact between a plurality of land grid array (LGA) pads on the bottom surface of the semiconductor package and the pogo pins/elastomer columns in a test socket of a semiconductor testing equipment/tool.

In an aspect, the semiconductor testing equipment may include a thermal head assembly having a body with a recess that is unobstructed and designed to fit over a die on the semiconductor package. The body of the thermal head assembly may be gradually lowered onto the semiconductor package with a sealing member on the thermal head assembly being brought into engagement with a landing area on the semiconductor package forming a sealed chamber. The semiconductor package may be uniformly loaded by introducing a gas (e.g., air) and incrementally increasing the gas pressure in the sealed chamber while applying increasing mechanical load on the sealing member onto the landing area on the periphery of the semiconductor package to prevent leakage. Once the chamber is fully sealed, the combined internal pressure from the circulating gas and a sealing perimeter load may be sufficient to enable the proper socketing of the semiconductor package. Thereafter, the gas may be replaced with a circulating liquid refrigerant (e.g., water), at equivalent pressure, to remove the heat generated during the testing of the semiconductor package.

**In** a further aspect, following the testing of the semiconductor package, the liquid refrigerant may be replaced with air, and the sealed chamber pressure and force on the sealing member may be uniformly and incrementally reduced to prevent semiconductor package stresses and die cracking due to warpage/bending. The semiconductor package may be dried by the air being circulated in the sealed chamber while the gas pressure (i.e., load) is being reduced. Finally, the thermal head assembly may be fully raised and the semiconductor package may be removed from the test socket.

The present disclosure provides a semiconductor testing equipment that includes a thermal head assembly having a body with a perimeter sidewall enclosing an unobstructed recess, a sealing member positioned on a bottom surface of the perimeter sidewall, a first fluid conduit having an outlet connecting to the unobstructed recess, a second fluid conduit having an inlet connecting to the unobstructed recess, a gas supply valve coupled to the first fluid conduit, and a liquid supply valve coupled to the first fluid conduit.

In an aspect, the unobstructed recess forms a sealed chamber with a semiconductor package positioned for testing. In addition, the first fluid conduit permits the flow of a gas and a liquid into the sealed chamber from the outlet to the inlet of the second fluid conduit that is unobstructed while the gas or liquid is applying pressure to the semiconductor package. The semiconductor testing equipment further includes a test socket configured to receive the semiconductor package, which is positioned under the thermal head assembly, and a plurality of pins disposed in the test socket for engaging a plurality of landing pads on the semiconductor package when the semiconductor package is positioned in the test socket. In an aspect, the sealing member may be made of a resilient elastomeric material and is positioned to engage with a landing area on a semiconductor package.

The present disclosure is further directed to a thermal head assembly having a body with a downward-facing perimeter sidewall enclosing an unobstructed recess, a sealing member positioned on a bottom surface of the perimeter sidewall, a first fluid conduit having an outlet connecting to the unobstructed recess and a second fluid conduit having an inlet connecting to the unobstructed recess. **In** this aspect, the thermal head assembly further includes a gas supply valve and a liquid supply valve coupled to the first fluid conduit, and a gas return valve and a liquid return valve coupled to the second fluid conduit.

The present disclosure is also directed to a method that includes providing a semiconductor package having a die positioned on a substrate and a landing area positioned on the substrate surrounding the die, providing a semiconductor testing equipment comprising a thermal head assembly having a body with an unobstructed recess, a sealing member positioned proximally to the unobstructed recess, and a test socket configured to receive the semiconductor package, disposing the semiconductor package in the test socket and positioning the thermal head assembly to align the sealing member with the landing area on the substrate and to have the unobstructed recess cover the die, applying a downward force on the sealing member to form a sealed chamber over the die, filling the sealed chamber initially with a gas to pressurize the sealed chamber, and replacing the gas in the sealed chamber with a liquid and creating a liquid flow in the sealed chamber to remove heat from the die. A further aspect of the method includes removing the liquid from the sealed chamber, disengaging the thermal head assembly from the semiconductor package, and removing the semiconductor package from the test socket of the semiconductor testing equipment.

The technical advantages of the present disclosure include, but are not limited to:
(i) providing a load, i.e., downward pressure, using a pressurized fluid on a semiconductor package with a die that mitigates stress concentration on the die and reduces the risk of die cracks from such package loading;
(ii) increasing the thermal transfer area and enhancing the flow of the heat transfer fluid by using an unobstructed sealed chamber for the circulation of the heat transfer fluid; and
(iii) eliminating the need for costly standoff features in a thermal head assembly as well as potential stress concentrations and die cracks that may be caused by the standoffs.

To more readily understand and put into practical effect the present semiconductor testing equipment and methods for its use, which may mitigate the damage to semiconductor packages from the testing, particular aspects will now be described by way of examples provided in the drawings that are not intended as limitations. The advantages and features of the aspects herein disclosed will be apparent through reference to the following descriptions relating to the accompanying drawings. Furthermore, it is to be understood that the features of the various aspects described herein are not mutually exclusive and can exist in various combinations and permutations. For the sake of brevity, duplicate descriptions of features and properties may be omitted.

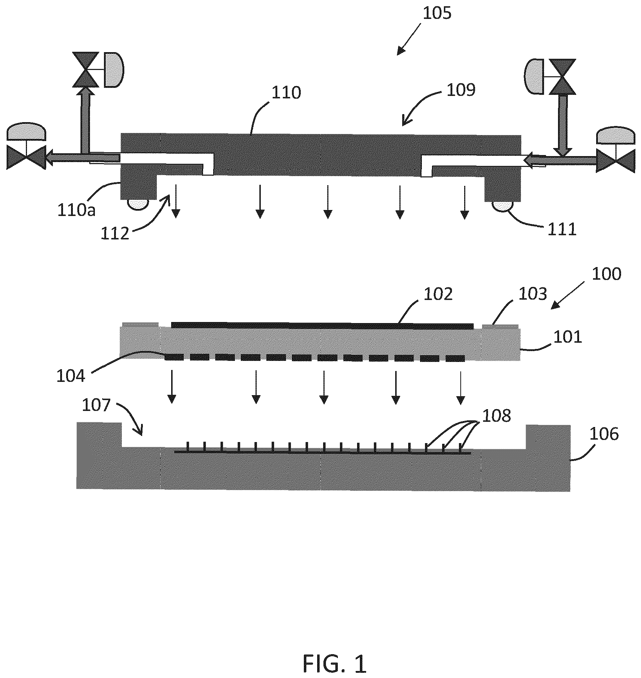

FIG. 1 shows an exemplary representation of a present semiconductor testing equipment 105 having a thermal head assembly 109 and a test socket 106 according to an aspect of the present disclosure.

In this aspect, the thermal head assembly 109 may have a body 110 having a sealing member 111 positioned on a bottom surface of a downward-facing perimeter sidewall 110a, which encloses an unobstructed recess 112. In an aspect, the unobstructed space 112 may accommodate a range of semiconductor package sizes, for example, of approximately 10 x 10 mm to 250 x 250 mm. In an aspect, the sealing member may be made of an elastomeric material such as polychloroprene, nitrile, ethylene propylene diene monomer, silicon rubber, styrenebutadiene rubber, and other natural and synthetic rubbers.

In this aspect, a test socket 106 may be positioned under the thermal head assembly 109 and configured to receive a semiconductor package 100 in a socket recess 107. The test socket 106 includes a plurality of pins 108 disposed in the socket recess 107. The plurality of pins 108 may be mechanical pins such as pogo pins or other types of push-connecting pins.

In this aspect, a semiconductor package 100, which includes a substrate 101 with a die 102 and a landing area 103 on its upper surface and a plurality of landing pads or land grid array pads 104 on its bottom surface, may be provided for testing using the semiconductor testing equipment 105. In a further aspect, the landing area 103 may be a stiffener for the semiconductor package 100. The semiconductor package 100 may be a "naked" package, i.e., without a heat spreader, including 2.5D and 3D packages (i.e., bare die packages).

When a semiconductor package is positioned in a test socket of a present semiconductor testing equipment, its plurality of landing pads is required to engage with a plurality of pins in the test socket. However, the "full" and complete engagement by all of the plurality of pins with the plurality of landing pads may not occur without pressure being provided by a thermal head assembly on the semiconductor package as discussed below.

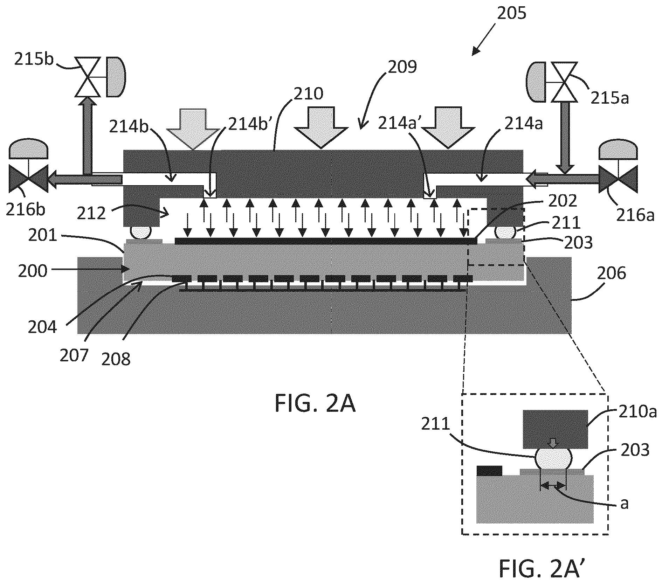

FIGS. 2A through 2C show exemplary representations of a present semiconductor testing equipment 205 having a thermal head assembly 209 and a test socket 206 engaging a semiconductor/die package 200 for testing according to an aspect of the present disclosure.

In the FIGS. 2A through 2C, the thermal head assembly 209 may have a body 210 having a downward-facing sealing member 211 positioned on the perimeter of an unobstructed recess forming a sealed chamber 212. In an aspect, the body 210 may include a first fluid conduit 214a having an outlet 214a' connecting to the sealed chamber 212 and a second fluid conduit 214b having an inlet 214b' connecting to the sealed chamber 212. In another aspect, a gas supply valve 215a may be coupled to the first fluid conduit 214a, and a liquid supply valve 216a may be coupled to the first fluid conduit 214a. In another aspect, a gas return valve 215b may be coupled to the second fluid conduit 214b and a liquid return valve 216b coupled to the second fluid conduit 214b.

The test socket 206 may be positioned under the thermal head assembly 209 and configured to receive the semiconductor package 200 in the socket recess 207. The test socket 206 includes a plurality of pins 208 disposed in the socket recess 207. In an aspect, the semiconductor package 200 includes a substrate 201 with a die 202 and a landing area 203 on its upper surface and a plurality of landing pads or land grid array pads 204 on its bottom surface.

In FIG. 2A, a force, which may be applied by a mechanical piston (not shown), on the body 210 of the thermal head assembly is translated to the sealing member 211 that engages with and presses against the landing area 203 at the periphery of the semiconductor package 200. As shown in FIG. 2A', the sealing member may have an elastic/flexible surface that forms a contract area "a" with the landing area 203 and provides a leak-proof for the sealed chamber 212 when it is pressurized with a gas or liquid. As the pressure of the gas in the sealed chamber 212 increases, the downward pressure on the body 210 may also need to be increased to prevent leakage at the sealing member 211.

In another aspect, the sealed chamber 212 is initially filled with a gas to gradually pressurize the sealed chamber 212. This is accomplished by configuring the gas supply valve 215a to introduce the gas into the first fluid conduit 214a and configuring the gas return valve 215b to control the outward flow of gas to slowly increase the pressure in the sealed chamber 212, while the liquid supply valve 216a is configured to prevent the flow of any liquid into the sealed chamber 212 and the liquid return valve 216b is configured to prevent the flow of the gas from the sealed chamber 212.

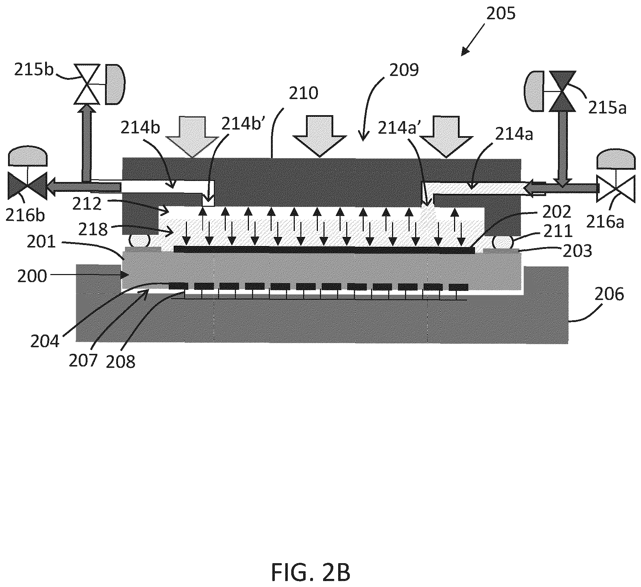

In FIG. 2B, the gas in the sealed chamber 212 may be replaced with a liquid 218 by configuring the gas supply valve 215a to prevent the flow of the gas into the first fluid conduit 214a and configuring the liquid supply valve 216a to permit the flow of the liquid 218 into the first fluid conduit 214a while configuring the gas return valve 215b to restrict the flow of gas from second fluid conduit to maintain the pressure in the sealed chamber 212 and configuring the liquid return valve216b to prevent the flow of the gas. In an aspect, the liquid 218 will flow into the sealed chamber 212 from the outlet 214a' of the first fluid conduit 214a and force out the gas through the inlet 214b' of the second fluid conduit 214b at a rate that maintains the pressure in the sealed chamber 212.

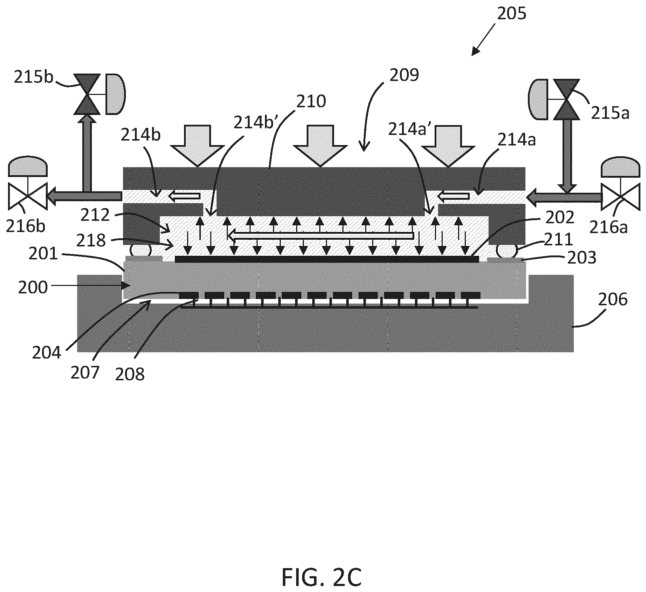

In FIG. 2C, the liquid 218 may fill the sealed chamber 212 thereby replacing the gas and a liquid flow is created in the sealed chamber 212 to remove heat from the die 202. In an aspect, the gas supply valve 215a may be configured to prevent the flow of any gas into the first fluid conduit 214a, and the liquid supply valve 216a may be configured to permit the flow of the liquid into the first fluid conduit 214a, while the gas return valve 215b may be configured to prevent the flow of the liquid from second fluid conduit 214b and the liquid return valve 216b may be configure to permit the flow of the liquid 218 at a rate to maintain the desired pressure in the sealed chamber 212 and on the semiconductor package 200. In an aspect, the flow of the liquid 218 from the outlet 214a' of the first fluid conduit 214a to the inlet 214b' of the second fluid conduit 214b is unobstructed.

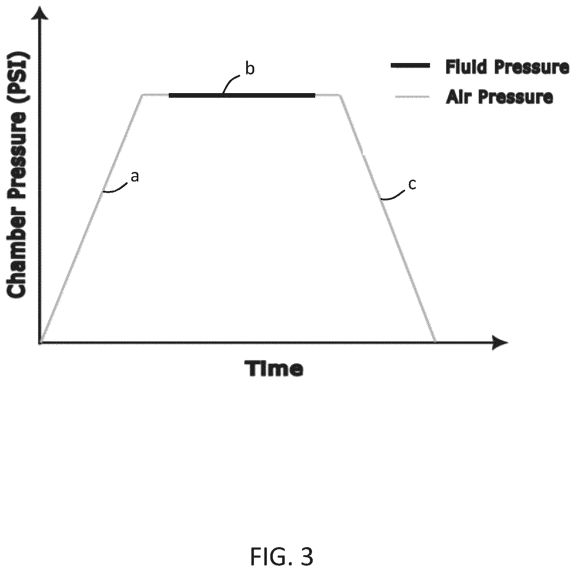

FIG. 3 shows an exemplary representation of an air and coolant fluid pressure cycle according to an aspect of the present disclosure. In the plot, the section "a" shows a gradual increase in the pressure in a sealed chamber from the introduction of a pressurized gas. In the section "b", the gas pressure may be replaced by the pressure from a pressurized liquid when the sealed chamber is filled by the liquid. In section "c" of the plot, the liquid may be removed while being replaced by a gas, and the pressure in the sealed chamber may be gradually reduced. This cycle may be repeated for the testing of each semiconductor package positioned in the present semiconductor testing equipment, which may provide a uniform pressure on the semiconductor package to eliminate or reduce any stress-induced damage or warpage that may be caused by a testing process on the semiconductor package.

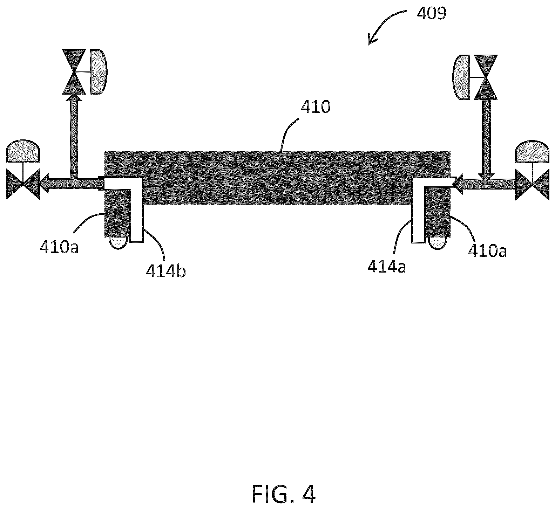

FIG. 4 shows an exemplary representation of another thermal head assembly 409 for a present semiconductor testing equipment according to an aspect of the present disclosure. In this aspect, the thermal head assembly 409 may have a body 410 with a sidewall 410a, a first fluid conduit 414a, and a second fluid conduit 414b that are positioned adjacent to the sidewall 410a. It should be understood that the positioning of a first fluid conduit and a second fluid conduct, as well as their shape and size, may be adjusted to achieve a desired rate of pressurization for a particular sealed chamber for a present semiconductor testing equipment.

In another aspect, it should be understood that the present thermal head assembly may be provided as a retrofit unit for existing semiconductor testing equipment to provide the benefits of a load, i.e., downward pressure, using a pressurized fluid on a semiconductor package with die that mitigates stress concentration on the die and reduces the risk of die cracks from such package loading from standoffs. In addition, the present thermal head assembly may enhance the flow of the heat transfer fluid by using an unobstructed sealed chamber for the circulation of the heat transfer fluid and increase the thermal transfer during the testing of the semiconductor package.

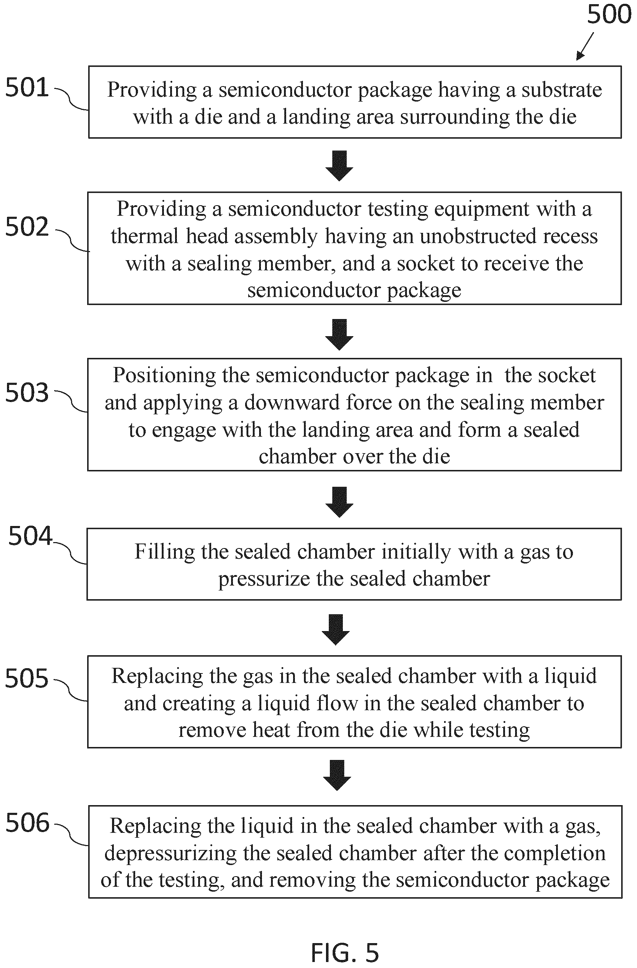

FIG. 5 shows a simplified flow diagram for an exemplary method for ramping up the pressure for testing a semiconductor package according to an aspect of the present disclosure.

The operation 501 may be directed to providing a semiconductor package having a substrate with a die and a landing area surrounding the die.

The operation 502 may be directed to providing a semiconductor testing equipment with a thermal head assembly having an unobstructed recess with a sealing member, and a test socket to receive the semiconductor package.

The operation 503 may be directed to positioning the semiconductor package in the test socket and applying a downward force on the sealing member to engage with the landing area and form a sealed chamber over the die.

The operation 504 may be directed to filling the sealed chamber initially with a gas to pressurize the sealed chamber. The pressurizing of the sealed chamber may occur concurrently with the application of the downward force on the sealing member to permit the gradual buildup of the pressure. The gas may be air, nitrogen, or another inert gas.

The operation 505 may be directed to replacing the gas in the sealed chamber with a liquid and creating a liquid flow in the sealed chamber to remove heat from the die while testing. The liquid may be water or a refrigerant solution. The pressure on the periphery of the semiconductor package, as well as the pressure on the upper surface of the semiconductor package from the gas and/or liquid, ensure that the landing grid array pads have electrical contact with the pins in the test socket of the semiconductor testing equipment.

The operation 506 may be directed to replacing the liquid in the sealed chamber with a gas and slowly depressurizing the chamber after the completion of the testing. Thereafter, the semiconductor package may be removed from the semiconductor testing equipment and another semiconductor package positioned for testing.

It should be understood that the scope of the present semiconductor testing equipment may be directed to a variety of backend semiconductor tests including burn-in testing, class/sort testing, system testing, interface unit testing, etc.

It will also be understood that any property described herein for a particular aspect of the semiconductor testing equipment and its method for testing a particular semiconductor package may also hold for any semiconductor package using the present method described herein. It will also be understood that any property described herein for a specific method may hold for any of the methods described herein. Furthermore, it will be understood that for any particular semiconductor testing equipment and the methods described herein, not necessarily all the components or operations described will be shown in the accompanying drawings or method, but only some (not all) components or operations may be disclosed.

To more readily understand and put into practical effect the present semiconductor testing equipment having a present thermal head assembly, they will now be described by way of examples. For the sake of brevity, duplicate descriptions of features and properties may be omitted.

### Examples

Example 1 provides a semiconductor testing equipment having a thermal head assembly including a body with a perimeter sidewall enclosing an unobstructed recess, a sealing member positioned on the bottom surface of the perimeter sidewall, a first fluid conduit having an outlet connecting to the unobstructed recess, and a second fluid conduit having an inlet connecting to the unobstructed recess, a gas supply valve coupled to the first fluid conduit and a liquid supply valve coupled to the first fluid conduit, a gas return valve coupled to the second fluid conduit and a liquid return valve coupled to the second fluid conduit. In an aspect, the semiconductor testing equipment includes a test socket that has- a recess with a plurality of pins and is positioned under the thermal head assembly.

Example 2 may include the semiconductor testing equipment of example 1 and/or any other example disclosed herein, for which the sealing member may be made of a resilient elastomeric material that flexibly engages with a landing area on an upper surface of a semiconductor package positioned for testing in the test socket.

Example 3 may include the semiconductor testing equipment of example 2 and/or any other example disclosed herein, for which the body is configured to exert a downward force on the sealing member and the unobstructed recess forms a sealed chamber with the semiconductor package when the sealing member is engaging the landing area on the semiconductor package.

Example 4 may include the semiconductor testing equipment of example 3 and/or any other example disclosed herein, for which the first fluid conduit permits a flow of a gas and a liquid into the sealed chamber, and the flow of the gas or liquid that applies uniform pressure on the semiconductor package as the flow moves unobstructed from the outlet of the first fluid conduit to the inlet of the second fluid conduit.

Example 5 may include the semiconductor testing equipment of example 4 and/or any other example disclosed herein, for which the gas supply valve is configured to control the flow of a gas into the sealed chamber, and the gas return valve is configured to control a flow of the gas out of the sealed chamber.

Example 6 may include the semiconductor testing equipment of example 4 and/or any other example disclosed herein, for which the liquid supply valve is configured to control the flow of a liquid into the sealed chamber, and the liquid return valve is configured to control a flow of the liquid out of the sealed chamber.

Example 7 may include the semiconductor testing equipment of example 2 and/or any other example disclosed herein, for which the plurality of pins in the test socket engages a plurality of landing pads on the semiconductor package positioned in the test socket.

Example 8 may include the semiconductor testing equipment of example 4 and/or any other example disclosed herein, for which the flow of the liquid pressurizes the sealed chamber and removes heat from the semiconductor package during the testing.

Example 9 provides a thermal head assembly including a body with a downward-facing perimeter sidewall enclosing an unobstructed recess, a sealing member positioned on the bottom surface of the perimeter sidewall, a first fluid conduit having an outlet connecting to the unobstructed recess, a second fluid conduit having an inlet connecting to the unobstructed recess, a gas supply valve coupled to the first fluid conduit, and a liquid supply valve coupled to the first fluid conduit.

Example 10 may include the thermal head assembly of example 9 and/or any other example disclosed herein, which further includes a gas return valve coupled to the second fluid conduit and a liquid return valve coupled to the second fluid conduit.

Example 11 may include the thermal head assembly example 10 and/or any other example disclosed herein, for which the sealing member may be made of a resilient elastomeric material, for which the sealing member is positioned to engage with a landing area on a semiconductor package to prevent leakage of a gas or a liquid.

Example 12 may include the thermal head assembly example 11 and/or any other example disclosed herein, for which the body is configured to exert a downward force on the sealing member to form a sealed chamber when the sealing member is engaging the landing area on the semiconductor package. In an aspect, the sealed chamber is formed by the unobstructed recess being joined with the semiconductor package.

Example 13 may include the thermal head assembly example 12 and/or any other example disclosed herein, for which the gas supply valve is configured to control a flow of gas into the sealed chamber and the gas return valve is configured to control a flow of the gas out of the sealed chamber.

Example 11 may include the thermal head assembly example 12 and/or any other example disclosed herein, for which the liquid supply valve is configured to control the flow of a fluid into the sealed chamber, and the liquid return valve is configured to control a flow of the fluid out of the sealed chamber.

Example 15 provides a method for testing a semiconductor package with a die positioned on a substrate and a landing area positioned on the substrate surrounding the die. The method includes providing a semiconductor testing equipment that includes a thermal head assembly having a body with an unobstructed recess, a sealing member positioned proximally to the unobstructed recess, and a test socket configured to receive the semiconductor package, disposing the semiconductor package in the test socket of the semiconductor testing equipment and positioning the thermal head assembly to align the sealing member with the landing area on the substrate and to have the unobstructed recess cover the die. In an aspect, the method further includes applying a downward force by the body on the sealing member to form a sealed chamber over the die, filling the sealed chamber initially with a gas to pressurize the sealed chamber, and replacing the gas in the sealed chamber with a liquid and creating a liquid flow in the sealed chamber to remove heat from the die during the testing of the semiconductor package.

Example 16 may include the method of example 15 and/or any other example disclosed herein, further including removing the liquid from the sealed chamber, disengaging the thermal head assembly from the semiconductor package, and removing the semiconductor package from the test socket of the semiconductor testing equipment.

Example 17 may include the method of example 15 and/or any other example disclosed herein, for which the thermal head assembly further includes a first fluid conduit having an outlet connecting to the sealed chamber, a second fluid conduit having an inlet connecting to the sealed chamber, a gas supply valve coupled to the first fluid conduit and a liquid supply valve coupled to the first fluid conduit to provide the gas and liquid, and a gas return valve coupled to the second fluid conduit and a liquid return valve coupled to the second fluid conduit to remove the gas and liquid.

Example 18 may include the method of example 17 and/or any other example disclosed herein, for which the filling of the sealed chamber initially with the gas to pressurize the sealed chamber further includes configuring the gas supply valve to introduce gas into the first fluid conduit and configuring the gas return valve to control the flow of gas to slowly increase the pressure in the sealed chamber, and configuring the liquid supply valve to prevent the flow of any liquid into the sealed chamber and configuring the liquid return valve to prevent the flow of the gas from the sealed chamber.

Example 19 may include the method of example 18 and/or any other example disclosed herein, for which replacing the gas in the sealed chamber with a liquid further includes configuring the gas supply valve to prevent the flow of the gas into the first fluid conduit and configuring the liquid supply valve to permit the flow of the liquid into the first fluid conduit, and configuring the gas return valve to restrict the flow from the second fluid conduit to maintain the pressure in the sealed chamber and configuring the liquid return valve to prevent the flow of the gas.

Example 20 may include the method of example 19 and/or any other example disclosed herein, for which the creating the liquid flow in the sealed chamber to remove heat from the die further includes configuring the gas supply valve to prevent the flow of the gas into the first fluid conduit and configuring the liquid supply valve to permit the flow of the liquid into the first fluid conduit, and configuring the gas return valve to prevent the flow of the liquid from the second fluid conduit and configuring the liquid return valve to permit the flow of the liquid while maintaining the pressure in the sealed chamber. In an aspect, the flow of the liquid from the outlet of the first fluid conduit to the inlet of the second fluid conduit is unobstructed.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words: coupling without direct contact) may be provided.

The terms "and" and "or" herein may be understood to mean "and/or" as including either or both of two stated possibilities.

While the present disclosure has been particularly shown and described with reference to specific aspects, it should be understood by those skilled in the art that various changes in form and detail may be made therein without departing from the spirit and scope of the present disclosure as defined by the appended claims. The scope of the present disclosure is thus indicated by the appended claims and all changes which come within the meaning and range of equivalency of the claims are therefore intended to be embraced.

## Claims

1. A thermal head assembly comprising:
a body comprising a downward-facing perimeter sidewall enclosing an unobstructed recess;
a sealing member positioned on a bottom surface of the perimeter sidewall;
a first fluid conduit having an outlet connecting to the unobstructed recess;
a second fluid conduit having an inlet connecting to the unobstructed recess;
a gas supply valve coupled to the first fluid conduit; and
a liquid supply valve coupled to the first fluid conduit.

2. The thermal head assembly of claim 1, further comprises a gas return valve coupled to the second fluid conduit and a liquid return valve coupled to the second fluid conduit;
preferably wherein the sealing member comprises a resilient elastomeric material, wherein the sealing member is positioned to engage with a landing area on a semiconductor package to prevent leakage of a gas or a liquid.

3. The thermal head assembly of any one of claims 1 or 2, wherein the body is configured to exert a downward force on the sealing member to form a sealed chamber when the sealing member is engaging the landing area on the semiconductor package, wherein the sealed chamber comprises the unobstructed recess and the semiconductor package;
preferably wherein the gas supply valve is configured to control a flow of a gas into the sealed chamber and the gas return valve is configured to control a flow of the gas out of the sealed chamber.

4. The thermal head assembly of any one of claims 1 to 3, wherein the liquid supply valve is configured to control a flow of a fluid into the sealed chamber, and the liquid return valve is configured to control a flow of the fluid out of the sealed chamber.

5. A semiconductor testing equipment comprising:
a thermal head assembly of any one of claims 1 to 4;
a gas return valve coupled to the second fluid conduit and a liquid return valve coupled to the second fluid conduit; and
a test socket comprising a recess having a plurality of pins, wherein the test socket is positioned under the thermal head assembly.

6. The semiconductor testing equipment of claim 5, wherein the sealing member comprises a resilient elastomeric material that flexibly engages with a landing area on an upper surface of a semiconductor package positioned for testing in the test socket.

7. The semiconductor testing equipment of any one of claims 5 or 6, wherein the body is configured to exert a downward force on the sealing member and wherein the unobstructed recess forms a sealed chamber with the semiconductor package when the sealing member is engaging the landing area on the semiconductor package.

8. The semiconductor testing equipment of any one of claims 5 to 7, wherein the first fluid conduit permits a flow of a gas and a liquid into the sealed chamber and the flow of the gas or liquid that applies uniform pressure on the semiconductor package as the flow moves unobstructed from the outlet of the first fluid conduit to the inlet of the second fluid conduit.

9. The semiconductor testing equipment of any one of claims 5 to 8, wherein the gas supply valve is configured to control a flow of a gas into the sealed chamber, and the gas return valve is configured to control a flow of the gas out of the sealed chamber; and/or
wherein the liquid supply valve is configured to control a flow of a liquid into the sealed chamber, and the liquid return valve is configured to control a flow of the liquid out of the sealed chamber.

10. The semiconductor testing equipment of any one of claims 6 to 9, wherein the plurality of pins in the test socket engages a plurality of landing pads on the semiconductor package positioned in the test socket.

11. The semiconductor testing equipment of any one of claims 5 to 10, wherein the flow of the liquid pressurizes the sealed chamber and removes heat from the semiconductor package during the testing.

12. A method comprising:
providing a semiconductor package comprising a die positioned on a substrate, and a landing area positioned on the substrate surrounding the die;
providing a semiconductor testing equipment comprising a thermal head assembly having a body with an unobstructed recess, a sealing member positioned proximally to the unobstructed recess, and a test socket configured to receive the semiconductor package;
disposing the semiconductor package in the test socket and positioning the thermal head assembly to align the sealing member with the landing area on the substrate and to have the unobstructed recess cover the die;
applying a downward force on the sealing member to form a sealed chamber over the die;
filling the sealed chamber initially with a gas to pressurize the sealed chamber; and
replacing the gas in the sealed chamber with a liquid and creating a liquid flow in the sealed chamber to remove heat from the die;
preferably the method further comprising:
removing the liquid from the sealed chamber;
disengaging the thermal head assembly from the semiconductor package; and
removing the semiconductor package from the test socket of the semiconductor testing equipment.

13. The method of claim 12, wherein the thermal head assembly further comprises:
a first fluid conduit having an outlet connecting to the sealed chamber, a second fluid conduit having an inlet connecting to the sealed chamber;
a gas supply valve coupled to the first fluid conduit and a liquid supply valve coupled to the first fluid conduit; and
a gas return valve coupled to the second fluid conduit and a liquid return valve coupled to the second fluid conduit.

14. The method of any one of claims 12 or 13, wherein the filling of the sealed chamber initially with the gas to pressurize the sealed chamber further comprises:
configuring the gas supply valve to introduce gas into the first fluid conduit and configuring the gas return valve to control the flow of gas to slowly increase a pressure in the sealed chamber; and
configuring the liquid supply valve to prevent the flow of any liquid into the sealed chamber and configuring the liquid return valve to prevent the flow of the gas from the sealed chamber.

15. The method of any one of claims 12 to 14, wherein the replacing the gas in the sealed chamber with a liquid further comprises:
configuring the gas supply valve to prevent the flow of the gas into the first fluid conduit and configuring the liquid supply valve to permit the flow of the liquid into the first fluid conduit; and
configuring the gas return valve to restrict the flow from the second fluid conduit to maintain the pressure in the sealed chamber and configuring the liquid return valve to prevent the flow of the gas;
preferably wherein the creating the liquid flow in the sealed chamber to remove heat from the die further comprises:
configuring the gas supply valve to prevent the flow of the gas into the first fluid conduit and configuring the liquid supply valve to permit the flow of the liquid into the first fluid conduit; and
configuring the gas return valve to prevent the flow of the liquid from the second fluid conduit and configuring the liquid return valve to permit the flow of the liquid while maintaining the pressure in the sealed chamber, wherein the flow of the liquid from the outlet of the first fluid conduit to the inlet of the second fluid conduit is unobstructed.
